**Europäisches Patentamt**

(19) **European Patent Office**

**Office européen des brevets**

(11) Publication number: **0 021 560**

**B1**

(12) **EUROPEAN PATENT SPECIFICATION**

(45) Date of publication of patent specification: **15.02.84**

(51) Int. Cl.³: **G 01 R 31/02**

(21) Application number: **80301115.4**

(22) Date of filing: **08.04.80**

(54) **A method of detecting electrical shorts.**

(30) Priority: **22.06.79 US 51204**

(43) Date of publication of application:
**07.01.81 Bulletin 81/1**

(45) Publication of the grant of the patent:
**15.02.84 Bulletin 84/7**

(84) Designated Contracting States:
**BE CH DE FR GB IT LI NL**

(56) References cited:
**DE - B - 1 947 569**

(73) Proprietor: **GENRAD, INC.**
**300 Baker Avenue**
**Concord Massachusetts 01742 (US)**

(72) Inventor: **Skilling, James K.**
**Bolton Road**
**Harvard, Massachusetts (US)**

(74) Representative: **Johnson, Terence Leslie et al,**
**Edward Evans & Co. Chancery House 53-64**
**Chancery Lane**
**GB-London WC2A 1SD (GB)**

Courier Press, Leamington Spa, England.

A method of detecting electrical shorts

The present invention relates to methods of detecting electrical shorts in electrical and electronic circuit boards, backplanes, cables and similar systems, being more particularly directed to techniques for achieving significant reduction in number of testing connections to electrical nodes required to find the fault—specifically, the shorted node pairs.

In present-day technology for the manufacturing of electrical or electronic circuits, the difficulty of producing such circuits without faults is mounting as the circuits are radically miniaturized and sub-miniaturized, and the complexity and multifunctions of the components thereof are strikingly increased. Manufacturers must test such circuit assemblies not only to ensure that components have been placed in the circuit properly and have not been damaged in assembly, but also to determine that the circuit as a whole functions properly. The art has struggled over the years to provide more efficient and higher speed testing for such circuits. The object of such testing, should a fault be discovered, is to pin-point the locations of the fault so that the newly-manufactured circuit can be quickly repaired and made functional. Sophisticated computer-aided techniques for the purpose have been developed such as the CAPS system of GenRad, Inc., the assignee of the present application, as described, for example in "Automatic Fault Location Using On-Line Simulation", Rene, Haas, Lutz, Henckels and David Schneider, Technical Paper Presented at the Institute of Electrical and Electronics Engineers International Convention and Exposition "Intercon 74", March 26—29, 1974. Another technique for improving test and diagnosis process involves manual probing and is described in "The Smart Probe—A New Diagnostic Tool," Test Systems Systems Division Application Note 1, General Radio Co. (now GenRad, Inc.) August, 1975.

A prevalent type of fault in today's technology is the unwanted short between two nodes of a circuit. Such shorts can be detected and located with much simpler techniques than the sophisticated methods mentioned above. Such sophisticated testing is, of course, obscured and slowed by the presence of shorts between nodes. Testing efficiency can be improved, therefore, if such shorts can be detected and removed before the sophisticated testing process is begun.

Although such shorts testing may prove a piece of equipment defective, however, it is of little value in indicating how the equipment can be repaired unless the nodes shorted together can be identified; so that the object of shorts testing is not only to detect the presence of shorts, but to identify the shorted nodes.

Another prior art testing method in this field is to be found in DE—B—1947569 in which a method for automatically testing a cable composed of a plurality of insulated conductors is disclosed. To perform the method a conductor of the assembly of conductors is tested consecutively against the others which are connected in parallel with respect to one another and which have not yet been tested. Once a fault has been detected, the individually chosen conductor is tested against each individual conductor of the remaining conductors in the assembly.

Testing for shorts is needed also in the manufacture of other electrical devices such as cables, backplanes, bare circuit boards, etc., and other types of apparatus, as well.

In accordance with the present invention, a technique has been evolved that departs rather radically from the testing connection philosophy developed through the years and enables vast reduction in number of required tests and time for short or related fault identification. It is in order, however, before describing the prior art and contrasting the same from the invention, to provide definitions of terms as used herein.

In connection with the application of the invention to the electrical field, the generic term "node" is used herein to connote an isolated electrical conductor or connection point. The word "short" connotes the (generally unwanted) presence of a short-circuit or, more generically, of an electrical resistance between two nodes of less than some preselected value. A "short detector" is apparatus having at least two connection leads which, when connected respectively to two nodes or groups of nodes, can detect the presence of a short between those nodes or groups of nodes.

In the prior art of shorts testing, various straight-forward techniques have been employed. The most thorough of these is to test each node pair separately. The first node is tested against the second, then the third, etc., and then the second node is tested against the third, then the fourth, etc., until finally the $(N-1)$th node is tested against the Nth. This requires

$$(N-1)+(N-2)+(N-3)+ \ldots +3+2+1$$

or $1/2\,(N^2-N)$ shorts tests. Because this number is of the order of magnitude of $N^2$, this method might be called the "N-Squared Test". When the number of nodes is large, this requires a very large number of shorts tests.

A modification of the above is the "Terminating N-Squared Test" which is identical to the "N-Squared Test" except that if a connection is found, further tests with the present first node of the pair are not executed. The connection to the first node is, rather moved to the next; and testing continues.

For example, if node 4 is found to be shorted to node 5, further testing with node 4 is discontinued and testing continues with node 5. If node 4 is shorted to some other higher-numbered node, say 7, node 5 will be also. It is impossible to determine whether 4 is shorted to 5 and also to 7, or whether 4 is shorted to 7 which is shorted to 5, etc. When, and only when shorts are present, this technique requires fewer tests than the N-Squared Test, and again shorted nodal pairs or groups are completely identified.

In further searching for methods of reducing the number of tests required for testing assemblies with large numbers of nodes, some manufacturers have used what might be called the "Linear Test". In this technique, each node is tested individually against all others, collectively. For N nodes, N tests are required. When shorted nodes are found, it is not determined to which other nodes they are shorted. This reduced amount of information is acceptable, in some cases, in return for the greatly reduced number of shorts tests required.

An object of the present invention, however, is to provide a new and vastly improved process or method of electrical short detection that enables testing for and identifying all node pairs which are shorted; and does so with a significantly smaller number of tests than is required by any of the above-described previously known methods.

The invention is thus particularly useful for testing any multiplicity of electrical nodes, such as multi-conductor cables, backplanes, and printed circuit boards, both before and after component parts are assembled thereto, and similar devices.

Other and further objects will be explained hereinafter and are, more particularly delineated in the appended claims.

In summary, from its broadest aspect, the invention embraces a method of detecting electrical shors between pairs of nodes in a plurality of nodes in an apparatus under test, which method comprises connecting one lead of a pair of leads from a short detector successively to each individual node of the plurality of nodes in the apparatus under test, and the other lead to the other nodes in a preselected manner to determine a short between respective ones of the node pairs wherein during the connection of said one lead to said each individual node, the other lead is connected to all of the remaining nodes of the said plurality of nodes collectively; and identifying during said connecting those nodes which are shorted to one or more other nodes between the leads, and thereupon connecting each thusly identified shorted node one at a time to one of the pair of leads while connecting the other lead successively to each of the other identified shorted nodes; and indicating when a shorted node pair is thus detected.

Since the primary thrust of the invention lies in the novel method or process in which conventional apparatus may be adapted to be used to effect a dramatic improvement in the efficiency of the shorts testing process, it is not believed that drawings are necessary to illustrate such known short detector apparatus with two leads and switch connections to nodes or groups of nodes. Two well-known realizations of such apparatus, are an ohmmeter, which actually measures resistance, and well-known means for comparing the measured value against a preselected value; or a conventional bridge circuit in which one of the four arms of the bridge is the device being tested, accessed at the nodes or groups of nodes being tested at that moment, with the direction of unbalance of the bridge indicating immediately whether the resistance is greater than or less than the preselected value.

In accordance with the invention, it has been found that the features of the normally unrelated, and generally considered incompatable. Linear type and N-Squared type searching philosophies before-mentioned, can be made consistent with one another to produce a synergestic and unexpected dramatic reduction in test requirements.

In the preferred or best mode of operation of the invention, two sequences of tests are performed. In the first sequence of tests, one lead of the short detector is connected to one node of the device being tested, and the other lead of the short detector is connected to all other nodes of the plurality of nodes of the device, simultaneously or concurrently. This is successively repeated for every node; thus requiring, for N nodes, N tests. Whenever a short is detected, the index of the node being individually connected is noted. At this point, therefore, while it is known that such nodes are shorted to some other nodes, it is not known to which other nodes.

The invention then turns to the carrying out of the second sequence of tests, in which one lead of the short detector is connected to one shorted node found and identified in the previous sequence of tests, and the other lead of the short detector is connected to successive of each of the identified shorted nodes. This is repeated for each pair of such shorted nodes requiring, for M shorted nodes $M(M-1)/2$ tests. Whenever a short is detected, the indices of the nodes comprising the node pair being tested are noted for reporting or indicating as a shorted node pair.

The startling reduction in tests required by the invention to find the shorted node pairs, over the number of tests required in the past with the N-Squared type searching, (the Linear searching being incapable of determining the shorted node pairs is demonstrated by the following table:

| Number of nodes N | Number of tests required by prior art N-squared search | Number of tests required by present invention | | | | |
|---|---|---|---|---|---|---|
| | | M=0 | M=2 | M=4 | M=6 | M=8 |
| 64 | 2016 | 64 | 65 | 70 | 79 | 92 |
| 128 | 8128 | 128 | 129 | 134 | 143 | 156 |
| 256 | 32640 | 256 | 257 | 262 | 271 | 284 |
| 512 | 130816 | 512 | 513 | 518 | 527 | 540 |
| 1024 | 523776 | 1024 | 1025 | 1030 | 1039 | 1052 |
| 2048 | 2096128 | 2048 | 2049 | 2054 | 2063 | 2076 |

As described before, the so-called "terminating N-Squared" search requires fewer tests when shorts are actually present. Since, in the method of the invention, all nodes found in the first step are involved in shorts, it is therefore particularly efficient to use the terminating version of the N-Squared search in the second sequence of tests of the invention. If that is done, the numbers in the columns of the above table for M=2 and higher will be even smaller than those shown; with the exact number of tests required depending upon the specific locations of the shorts and being thus not specifiable.

Further modifications will also occur to those skilled in this art, and such are considered to fall within the scope of the invention as defined in the appended claims.

## Claims

1. A method of detecting electrical shorts between pairs of nodes in a plurality of nodes in an apparatus under test, which method comprises connecting one lead of a pair of leads from a short detector successively to each individual node of the plurality of nodes in the apparatus under test, and the other lead to the other nodes in a preselected manner to determine a short between respective ones of the node pairs wherein during the connection of said one lead to said each individual node, the other lead is connected to all of the remaining nodes of the said plurality of nodes collectively; and identifying during said connecting those nodes which are shorted to one or more other nodes between the leads, and thereupon connecting each thusly identified shorted node one at a time to.one of the pair of leads while connecting the other lead successively to each of the other identified shorted nodes; and indicating when a shorted node pair is thus detected.

2. A method as claimed in claim 1 wherein upon identifying a shorted node pair, terminating the connecting, and proceeding to connect said one of the pair of leads to a next-identified shorted node, and thereupon connecting the other lead successively to each of other identified shorted nodes until a further shorted node pair is detected.

## Patentansprüche

1. Verfahren zum Auffinden von elektrischen Kurschlüssen zwischen Knotenpaaren einer Vielzahl von Knoten in einem getesteten Gerät, welches (Verfahren) darin besteht, daß eine Leitung eines Leitungspaares eines Kurzschlußdetektors nacheinander mit den einzelnen Knoten der Vielzahl von Knoten in dem getesteten Gerät und die andere Leitung mit den anderen Knoten in einer vorgewählten Weise verbunden werden, um einen Kurzschluß zwischen einem Knotenpaar festzustellen, wobei während der Verbindung der einen Leitung mit den einzelnen Knoten die andere Leitung mit allen übrigen Knoten der Vielzahl von Knoten gemeinschaftlich verbunden ist, daß während der Verbindung solche Knoten identifiziert werden, die einen Kurzschluß zu einem oder mehreren anderen Knoten zwischen den Leitungen aufweisen, daß dann jeder so identifizierte kurzgeschlossene Knoten einzeln mit einer der beiden Leitungen verbunden wird, während die andere Leitung nacheinander mit jedem anderen identifizierten kurzgeschlossenen Knoten verbunden wird, und daß angezeigt wird, wenn ein kurzgeschlossens Knotenpaar auf diese Weise aufgefunden ist.

2. Verfahren nach Anspruch 1, bei welchem beim Identifizieren eines kurzgeschlossenen Knotenpaares die Verbindung beendet und anschließend die eine Leitung des Leitungspaares mit dem nächsten identifizierten kurzgeschlossenen Knoten verbunden wird, und bei welchem dann die andere Leitung nacheinander mit jedem anderen identifizierten kurzgeschlossenen Knoten verbunden wird, bis ein weiteres kurzgeschlossenes Knotenpaar aufgefunden ist.

## Revendications

1. Procédé pour la détection de courts-circuits entre deux noeuds d'une pluralité de noeuds dans un appareil sous test, le dit procédé comprenant la connexion de l'un des deux conducteurs d'un détecteur de court-circuit successivement à chacun des noeuds de la pluralité de noeuds dans l'appareil sous test, et l'autre conducteur aux autres noeuds de façon présélectionnée de manière à détecter un court-circuit entre deux noeuds d'une paire, caractérisé en ce que, pendant la connexion du dit conducteur à chacun des dits noeuds, l'autre conducteur est connecté à tous les autres noeuds de la dite pluralité de noeuds collectivement, et on identifie pendant la dite connexion les noeuds qui sont en court-circuit avec un ou plusieurs autres noeuds entre les conducteurs et puis on relie chacun des noeuds en court-circuit ainsi identifiés un par un à l'un des deux conducteurs tandis que l'on relie l'autre conducteur successivement à chacun des autres noeuds identifiés en court-circuit, et l'on indique lorsque deux noeuds en court-circuit sont ainsi détectés.

2. Procédé selon la revendication 1, caractérisé en ce qu'après avoir identifié deux noeuds en court-circuit, on termine la connexion et on procède à la connexion de l'un des dits deux conducteurs au noeud identifié suivant en court-circuit, puis on connecte l'autre conducteur successivement à chacun des autres noeuds identifiés en court-circuit jusqu'à ce que deux autres noeuds en court-circuit soient détectés.